## Europäisches Patentamt
## European Patent Office
## Office européen des brevets

(19)

(11) Veröffentlichungsnummer : **0 065 083**
**B1**

(12)

# EUROPÄISCHE PATENTSCHRIFT

(45) Veröffentlichungstag der Patentschrift :
24.04.85

(51) Int. Cl.⁴ : **G 06 K 19/06**

(21) Anmeldenummer : 82101918.9

(22) Anmeldetag : 10.03.82

(54) **Ausweiskarte mit eingelagertem IC-Baustein.**

(30) Priorität : 08.05.81 DE 3118298

(43) Veröffentlichungstag der Anmeldung :
24.11.82 Patentblatt 82/47

(45) Bekanntmachung des Hinweises auf die Patenterteilung : 24.04.85 Patentblatt 85/17

(84) Benannte Vertragsstaaten :
BE CH FR GB IT LI NL SE

(56) Entgegenhaltungen :
EP-A- 0 037 760
GB-A- 2 011 671
US-A- 3 761 892

(73) Patentinhaber : GAO Gesellschaft für Automation und
Organisation mbH
Euckenstrasse 12
D-8000 München 70 (DE)

(72) Erfinder : Hoppe, Joachim
Breisacherstrasse 1
D-8000 München 80 (DE)
Erfinder : Haghiri-Tehrani, Yahya
Zieblandstrasse 25
D-8000 München 40 (DE)

(74) Vertreter : Kador . Klunker . Schmitt-Nilson . Hirsch
Corneliusstrasse 15
D-8000 München 5 (DE)

Jouve, 18, rue St-Denis, 75001 Paris, France

## Beschreibung

Die Erfindung betrifft eine Ausweiskarte mit eingelagertem IC-Baustein zur Verarbeitung elektrischer Signale gemäß Oberbegriff des Anspruchs 1.

Aus der DE-AS 29 20 012 ist bereits eine Ausweiskarte mit eingebettetem IC-Baustein bekannt. In dieser Ausweiskarte ist der Baustein mit allen Zuleitungen und Kontakten auf einem separaten Trägerelement befestigt und in ein Fenster der Ausweiskarte eingesetzt, wobei sich die Kontaktflächen des Trägerelements an der Oberfläche der Karte befinden und frei zugänglich sind. IC-Bausteine hoher Komplexität, die in Ausweiskarten eingebaut werden, sollten solchen Anforderungen genügen wie geringer Platzbedarf, d. h. kleine Abmaße des Bauelements und geringer Energieverbrauch.

Komplexe integrierte Schaltungen mit hoher Packungsdichte und geringem Energieverbrauch werden heute vorwiegend in MOS-Technologie gefertigt.

Wie allgemein bekannt sind MOS-Bausteine, d. h. Schaltungen mit hohen Eingangswiderständen, gegen äußere elektrische Felder bzw. elektrostatische Aufladungen äußerst empfindlich.

Es gibt daher für den Umgang mit IC-Bausteinen in MOS Technik einschlägige Vorschriften, die zum Schutz der Bauelemente streng einzuhalten sind. Dies betrifft sowohl die Herstellung und Lagerung als auch die Verarbeitung des IC-Bausteins. Wie leicht einzusehen ist, können diese Vorschriften nur bedingt eingehalten werden, wenn derartige Bausteine in Ausweiskarten eingebaut sind. In der oben zitierten Schrift sind für den IC-Baustein und die Kontakte keine besonderen Schutzmaßnahmen getroffen gegen etwaige Beschädigungen durch äußere elektrische Felder bzw. elektrostatische Aufladungen. Derartige Felder und Aufladungen können schon im normalen täglichen Gebrauch unter ungünstigen Verhältnissen den empfindlichen IC-Baustein gefährden.

Die potentielle Gefährdung von Bausteinen in MOS-Technik liegt darin, daß die Gatespannungen je nach Typ zwischen 20 und 500 V liegen darf und wegen der hohen Eingangswiderstände bereits statische Aufladungen die Spannungsdifferenz zwischen Gate und Drain so groß werden lassen, daß die $SiO_2$-Sperrschicht durchschlagen und das Bauelement zerstört bzw. beschädigt wird. Statische Aufladungen dieser Größenordnung sind im täglichen Umgang bei bestimmten Umweltbedingungen nicht ungewöhnlich. Gerade bei Kunststoff-Ausweiskarten stellen die durch Reibung und dergleichen erzeugten statischen Aufladungen somit eine mögliche Gefahrenquelle für die Funktionsfähigkeit von IC-Bausteinen in Ausweiskarten dar.

Aus der GB-A-2 011 671 ist ein Taschenterminal für elektronische Speicherkarten bekannt, welches bereits einen gewissen Schutz vor dem zerstörenden Einfluß elektromagnetischer Wellen und statischer Aufladungen bietet, welche von der Oberseite des Taschenterminals her einwirken. Dazu wird an der Innenseite des Taschenterminals eine leitfähige Schicht mit Aussparungen im Bereich der Kopplungsmittel vorgesehen. Da das Taschenterminal auf der Rückseite im mittleren Drittel, also auch im Bereich der zu schützenden Speicherelemente der Speicherkarte, offen ist, bildet diese Anordnung keinen geschlossenen Faradayschen Käfig. Von der Rückseite des Taschenterminals können also zerstörende Einflüsse elektromagnetischer Natur durchaus auf die Speicherkarte einwirken.

Aufgabe der Erfindung ist es daher, den IC-Baustein in Ausweiskarten gegen äußere elektrische Felder und elektrostatische Aufladungen weitgehend zu schützen.

Diese Aufgabe wird erfindungsgemäß durch die im kennzeichnenden Teil des Anspruchs 1 angegebenen Merkmale gelöst.

In der EP-A-0 037 760, die auf einer älteren Anmeldung beruht, ist bereits vorgeschlagen, dem oben angesprochenen Problem dadurch zu begegnen, daß der IC-Baustein und die zugehörigen Koppelelemente in ein elektrisch leitendes Kunststoffmaterial eingebettet werden. Das elektrisch leitende Kunststoffmaterial darf nicht zu schlecht leiten, damit die gewünschte Schutzwirkung erzielt wird, andererseits darf es aber nicht zu gut leiten, weil ansonsten unerwünschte Kurzschlüsse entstehen könnten. In der Praxis erweist sich jedoch eine derartige Maßnahme als nicht sinnvoll. Aufgrund der relativ hohen Leitfähigkeit des Materials kommt es zu Schwierigkeiten bei der Datenübertragung bzw. bei der Stromversorgung. Als Alternative ist in der EP-A-0 037 760 angegeben, den IC-Baustein und die zugehörigen Koppelelemente vollständig mit einem isolierenden Material zu umgeben und in das Material eine den Baustein und die Koppelelemente teilweise umhüllende Metallschicht anzuordnen, wobei an denjenigen Stellen dieser umhüllenden Metallschicht Öffnungen ausgebildet sind, die im Bereich der Kopplungselemente liegen, so daß durch die Öffnungen der Metallschicht ein Zugriff zu den Koppelelementen möglich ist. Diese Öffnungen müssen relativ groß bemessen sein, um einen freien Zugang zu den Kopplungsmitteln zu haben, andererseits müssen die Öffnungen aber auch so bemessen sein, daß die Gefahr von direkten Überschlägen zwischen der leitenden Umhüllung und den Kopplungsmitteln ausgeschaltet ist. In einer weiteren abgewandelten Ausführungsform offenbart die EP-A-0 037 760 noch eine Kombination der oben erläuterten Vorschläge. Diese Kombination weist sämtliche oben geschilderten Nachteile auf.

Die erfindungsgemäße Anwendung der Schutzmaßnahme kann sowohl mit kartentechnologischen Mitteln als auch durch eine entsprechende Behandlung des Trägerelements mit integr. IC-Baustein erfolgen. Bei der Verlagerung der Schutzmaßnahmen in den kartentechnologischen Sektor werden leitfähige Materialien bzw. Folien partiell oder über die gesamte Kartenfläche in die Karte integriert oder als Deckschichten verwendet und anschließend leitend verbunden, so daß sich eine leitfähige und die Funktion eines Faraday' schen Käfig erfüllende Umhüllung des IC-Bausteins samt Kopplungseinrichtungen ergibt. Dabei muß jedoch sichergestellt sein, daß die Kopplungseinrichtungen keine leitende Verbindung mit den leitfähigen Materialien haben.

Bei der Anwendung der erfindungsgemäßen Schutzmaßnahme auf das Trägerelement mit dem IC-Baustein wird die leitende Umhüllung auf das Trägerelement aufgebracht, bevor dieses in die Karte eingebaut wird.

Die erfindungsgemäße Schutzmaßnahme eignet sich für verschiedene Datenübertragungsverfahren bei IC-Bausteinen. Diese Datenübertragungsverfahren werden im folgenden am Beispiel eines erfindungsgemäß geschützten Trägerelements dargestellt ; sie eignen sich aber ebenso für kartentechnologisch geschützte Karten.

Bei einer kontaktlosen Version geschieht die Kommunikation zwischen IC-Baustein und Lese-Schreibeinrichtung über optoelektronische Kopplung. In einer solchen Ausführung wird das Trägerelement isolierend eingebettet und von einer leitenden Umhüllung umgeben, wobei Isolier- und Leitermaterial in dem für die optische Kopplung benutzten Spektralbereich transparent sind. Dies kann beispw. durch entsprechend dünne Schichten oder durch bekannte transparente Leitermaterialien erreicht werden.

Bei galvanischer Ankopplung wird das Trägerelement mit IC-Baustein und Kontaktflächen ebenfalls vollständig in eine Isolierschicht eingebettet und mit leitendem Material umhüllt. In diesem Fall sind jedoch keine besonderen optischen Anforderungen an die Materialien zu stellen, da der Datenabgriff vorzugsweise durch dünne Kontaktierungsstifte geschieht, die abgesehen von der Spitze isolierend ummantelt sind. Zur Verbindung mit den Kontaktflächen durchstechen die Stifte das leitende und das isolierende Material, wobei die Schichten vorzugsweise elastische Eigenschaften aufweisen, so daß sich die Öffnungen in den Schichten nach der Kontaktierung weitgehend wieder schließen. Da die Kontaktnadeln isolierend ummantelt sind, kann bei derartiger Kontaktierung, trotz der leitenden Umhüllung, das Kurzschließen der Kontaktstifte vermieden werden.

Vorteilhaft bei diesen Ausführungen ist, daß die leitende Schicht einen vollständig geschlossenen Faraday' schen Käfig bildet und sich eventuelle statische Aufladungen nur auf der Oberfläche des leitenden Materials befinden, jedoch keine Wirkung auf den eingeschlossenen IC-Baustein haben. Damit sind Ausweiskarten, bei denen der empfindliche IC-Baustein einen derartigen Schutz aufweist, in ihrer Funktionsfähigkeit weitaus unanfälliger gegen elektrische Felder bzw.

elektrostatische Aufladungen als herkömmliche Ausweiskarten mit IC-Baustein, bei denen keine diesbezüglichen Schutzmaßnahmen getroffen sind.

Wenn die elektrisch leitfähige Schicht das Trägerelement vollständig umhüllen soll, kann die Aufbringung der Schicht, im einfachsten Fall durch Tauch- und Sprühverfahren, ohne größere Schutzmaßnahmen erfolgen. Das vorübergehende Abdecken von Kontakten oder dergl. ist weder notwendig noch erwünscht, wodurch auf jede Art von Masken während der Umhüllung verzichtet werden kann.

Bei der Verwendung von thermoplastischen, elastisch leitfähigen oder leitfähig beschichteten Folien, sind darüber hinaus herkömmliche Kartentechnologien anwendbar, die bei der Kartenherstellung trotz Einbeziehung der erfindungsgemäßen Schutzmaßnahmen keinerlei Zusatzmaßnahmen notwendig machen. Die Erfindung weist somit einen hohen Schutzwert auf, der mit vernachlässigbarem zusätzlichen Aufwand erreichbar ist.

Weitere Einzelheiten der Erfindung ergeben sich aus den nachstehend aufgeführten Figuren.

Figur 1 Ausweiskarte mit IC-Baustein

Figuren 2, 3, 4, 5 kartentechnologische Schutzmaßnahmen

Figur 6 Trägerelement mit galvanischer Ankopplung

Figur 7 Trägerelement mit optoelektronischer Ankopplung

Figur 8 Ausweiskarte mit Schutzetui vor elektrischen Feldern.

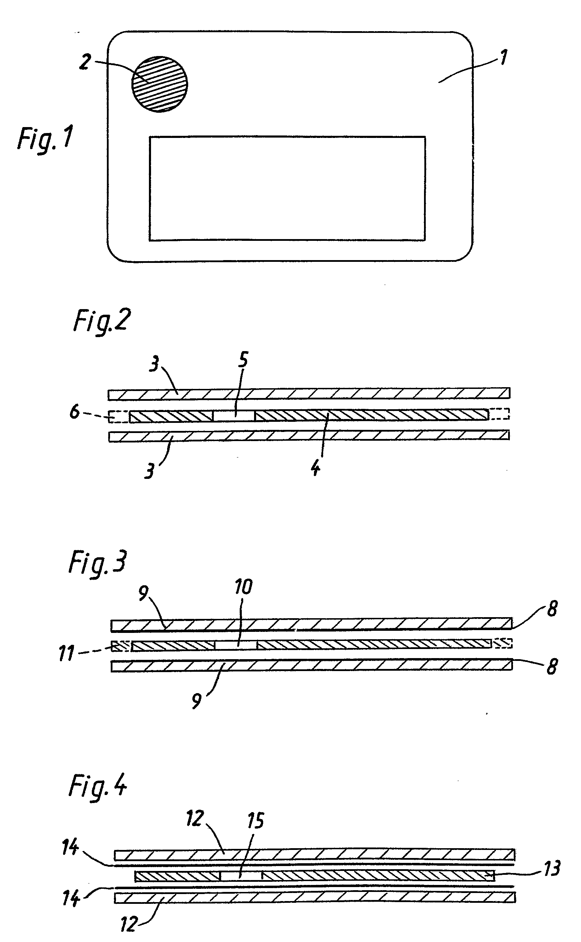

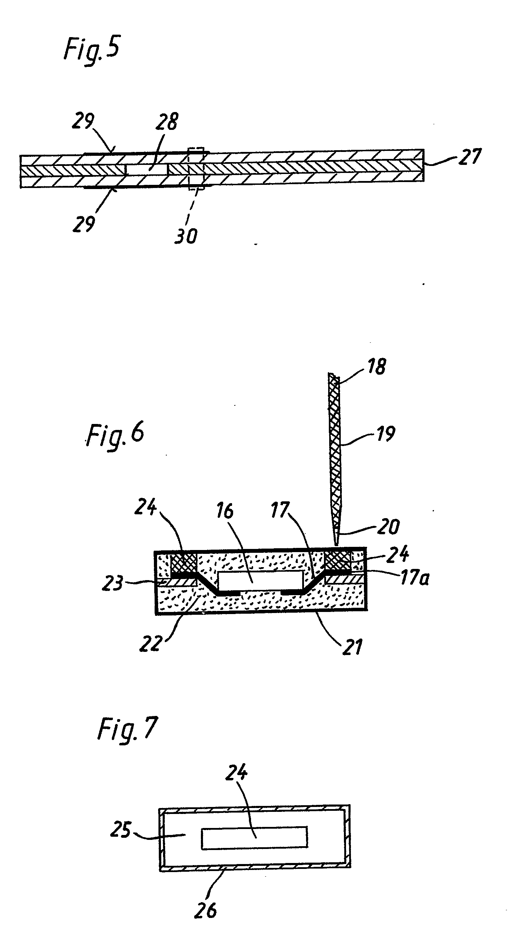

Fig. 1 zeigt eine Ausweiskarte 1, in die das Trägerelement mit dem IC-Baustein 2 eingelagert wird, wobei der erfindungsgemäße Schutz des empfindlichen IC-Bausteins durch kartentechnologische bzw. direkt am Trägerelement durchgeführte Maßnahmen erzielt wird. Verschiedene Ausführungsformen des durch kartentechnologische Maßnahmen erreichten Schutzes zeigen die Fig. 2, 3, 4 und 5. Weitere am Trägerelement selbst vorgesehene Maßnahmen sind in den Fig. 6 und 7 dargestellt.

In Fig. 2 wird das Trägerelement mit dem IC-Baustein 5 in eine Aussparung des Karteninletts 4 gesetzt und zwischen zwei elektrisch leitfähigen Folien 3 kaschiert. Im Falle eines nicht leitfähigen Inletts 4 muß dafür gesorgt werden, daß die leitfähigen Deckfolien 3 am Rand leitend verbunden werden, z. B. durch einen elektrisch leitfähigen Rahmen 6, der auch aus dem gleichen Material wie die Deckfolien 3 bestehen kann. Ein anderes Verfahren zur Herstellung einer elektrisch leitenden Randverbindung zwischen den beiden Deckfolien 3 bieten, im Zusammenhang mit elektrisch leitfähigen Folien, die bei der Herstellung randverschweißter Ausweiskarten hinlänglich bekannten Techniken (siehe z. B. DE-PS 27 56 691).

Fig. 3 zeigt eine andere Ausführungsform einer erfindungsgemäß geschützten Ausweiskarte mit IC-Baustein, wo als Deckfolien 9 z. B. PVC-Folien verwendet werden, die auf der Innenseite eine leitfähige Beschichtung 8 aufweisen. Für den Fall, daß die leitfähige Beschichtung 8 nicht transparent ist, befindet sich das Druckbild zwischen Deckfolie 9 und leitender Beschichtung 8.

Die leitende Randverbindung kann wieder mittels eines leitenden Folienrahmens 11 mit einem der oben geschilderten Verfahren hergestellt werden.

In dem in Fig. 4 dargestellten Ausführungsbeispiel besteht die leitende Schicht 14 aus einer zwischen Kaschierfolie 12 und Karteninlett 13 eingelagerten leitfähigen Schicht bzw. Folie. Das Karteninlett ist jedoch insgesamt schmaler als die Schichten 14, damit diese beim Kaschieren eine Verbindung eingehen können.

Fig. 5 zeigt eine erfindungsgemäß geschützte Ausweiskarte, wo elektrisch leitfähige Schichten 29 im Bereich des Trägerelements 28 auf der Ober- und Unterseite der Karte 27 aufgebracht sind. Die Schichten 29 können beispielsweise aufgedruckt oder als leitfähiger Lack aufgetragen sein. Bei ausreichender Transparenz können sich die Schichten 29 auch über die gesamte Kontaktoberfläche erstrecken. Wichtig bei dieser Ausführungsform ist die leitende Verbindung 30 zwischen den Schichten, die aus einer Art Durchkontaktierung besteht, wobei z. B. ein leitfähiger schmaler Metallstreifen durch eine schmale Öffnung in der Karte geführt, vor oder beim Kaschieren umgeklappt und eventuell in die Ausweiskarte eingedruckt wird. Diese Art der Randverbindung eignet sich auch für die vorher geschilderten Ausführungsbeispiele, wobei auf die Tatsache, daß der Faradaykäfig über die Dicke der Karte nicht vollständig geschlossen ist, im folgenden noch näher eingegangen wird.

In Fig. 6 ist ein erfindungsgemäßes Trägerelement mit IC-Baustein 16 für galvanische Ankopplung dargestellt.

In einem Fenster des Folienträgers 23 befindet sich der IC-Baustein 16, von den Leiterbahnen 17 gehalten und mit einem Isoliermaterial 22 vergossen. Im Bereich der Kontaktflächen 17a sind Aussparungen vorgesehen, die mit einem elastischen Isoliermaterial 24 ausgefüllt werden. In diesem Fall kann das Isoliermaterial 22 beliebig starr ausgeführt sein. In Abhängigkeit vom jeweiligen Anwendungsfall ist aber auch die vollständige Einbettung in elastisches Isoliermaterial denkbar, wodurch auf die Aussparungen und die zusätzlichen elastischen Isoliermaterialien 24 verzichtet werden kann, was die Herstellung des Trägerelements vereinfacht. Durch entsprechend dick ausgeführte Kontakte 17a (zusätzliche Kontaktlöcher etc.) kann die über den Kontakten angeordnete Isolierschicht auch entsprechend dünn ausgeführt werden, wodurch die Verwendung weniger elastischer Materialien ebenfalls ermöglicht wird. Die gesamte Anordnung wird dann mit einer leitenden Schicht 21 eingehüllt, die ebenfalls aus elastischem Material bestehen kann. Der Datenabgriff geschieht durch dünne Kontaktierungsstifte 18, die abgesehen von der Spitze 20 mit einer isolierenden Umhüllung 19 versehen sind. Zur Verbindung mit den Kontaktflächen 17a durchstechen die Kontaktierungsstifte 18 die elastisch leitende Schicht 21 und das elastische Isoliermaterial 24, bis die Spitzen 20 die Kontaktflächen 17a berühren. Die isolierende Umhüllung 19 ragt dabei soweit in den Bereich der Kontaktspitzen vor, daß die Nadeln in der Prüfposition nicht von der leitfähigen Schicht 21 kurzgeschlossen werden.

Nach der Kontaktierung können sich die elastischen Schichten 24 und 21 im Bereich der Öffnungen wieder schließen, so daß der Faraday'sche Käfig wieder geschlossen ist. Die leitende Schicht 21 kann beispw. durch Aufdampfen eines leitenden Materials auf das Trägerelement oder Eintauchen desselben in einen leitenden Lack erzeugt werden.

Eine andere Ausführungsform der Erfindung bildet die in Fig. 7 dargestellte Anordnung mit optoelektronischer Ankopplung. Ein IC-Baustein mit diesem Ankopplungsverfahren ist beispielhaft in der DE-OS-29 26 867 beschrieben. Fig. 7 zeigt einen IC-Baustein 24 dieser Bauart von einer Isolierschicht umgeben, die im für die optoelektronische Ankopplung benutzten Spektralbereich transparent ist. Die leitende Umhüllung 26 der gesamten Anordnung muß ebenfalls in diesem Spektralbereich transparent sein.

Es ist aber ebenso möglich, nur die Bereiche der Umhüllung 25, 26 optisch transparent auszubilden, die gerade über den lichtempfindlichen, bzw. lichtaussendenden für die Ankopplung und Energieversorgung benutzten Bauelemente liegen. Die optische Transparenz kann dabei sowohl durch transparente Materialien als auch durch sehr dünne Schichten sowie durch Gitter oder netzförmige Umhüllungen realisiert sein. Vorteilhaft bei den optoelektronischen Ankopplungsverfahren ist, daß auch bei sehr langer Gebrauchsdauer der Karte die Umhüllungen 11, 12 immer vollständig geschlossen bleiben und keine Materialermüdung infolge häufiger Kontaktierung zu einer Verminderung der Schutzwirkung durch bleibende Öffnungen verursacht durch die Kontaktierungsstifte, führen kann.

Entscheidend für die potentielle Verminderung der Schutzwirkung sind die Stärke eines äußeren Feldes, der Durchmesser der Öffnungen und der Abstand des zu schützenden Bauteils von den Öffnungen. Unter bestimmten Voraussetzungen z. B. bei schwachen Feldern oder bei großem Abstand des zu schützenden Bauelements von nicht zu weiten Öffnungen ist es daher auch möglich, die leitende Schicht als Gitter auszubilden. Dabei erübrigt es sich, die leitende Schicht wie bei der oben geschilderten galvanischen Kopplung elastisch zu gestalten, da die Kontaktierung durch die Maschenöffnungen eines derartigen Faraday'schen Käfigs geschehen kann.

Bei optoelektronischer Kopplung kann bei Verwendung eines elektrisch leitenden Gitters u. U. auch auf die Transparenzeigenschaft der Leiterschicht verzichtet werden, wenn durch die Öffnungen genügend Licht zur Energie- und Datenübertragung gelangt.

Werden die oben genannten Bedingungen erfüllt, ist es auch bei den kartentechnologischen Schutzmaßnahmen möglich, die leitenden Schichten bzw. eingelegten Folien oder Materialien als Gitter auszubilden oder netzförmig mit leitendem Material bedruckte Folien zu verwenden. Dabei müssen sich die leitenden Flächen oder Gitter nicht über den gesamten Kartenbereich erstrecken, sondern brauchen, wie in Fig. 5 beispielsweise dargestellt, nur den Bereich des Trägerelements überdecken und an einer Stelle am Rand leitend verbunden werden, z. B. durch die erwähnte Form einer Art Durchkontaktierung. Die Verminderung der Schutzwirkung ist bei dünnen Karten vernachlässigbar gering, so daß die Funktion als Faradaykäfig zu wirken, erhalten bleibt.

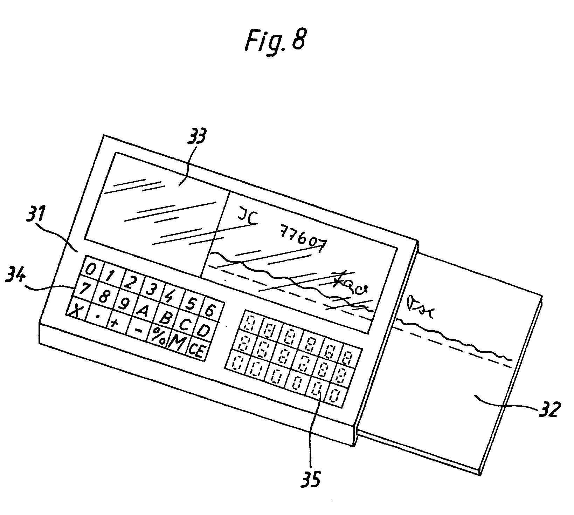

In einer anderen Ausführungsform, die in Fig. 8 dargestellt ist, wird der angestrebte Schutz vor elektrostatischen Feldern mittels eines « lösbaren » Faraday' schen Käfigs erzielt, der von der Ausweiskarte getrennt werden kann und auf diese Weise während der Datenübertragung von der Karte entfernbar ist. Aufbauend auf diesen Grundgedanken wird die Ausweiskarte 32 permanent in einem Etui aufbewahrt, welches innen eine leitende Beschichtung aufweist. Zum Lese-Schreibbetrieb wird das Etui 31 mit der Karte 32 in einen entsprechenden Automaten geführt, der die Karte selbsttätig aus dem Etui entnimmt und nach Beendigung des Kommunikationsvorgangs ins Etui 31 zurückschiebt. Wie in Fig. 8 dargestellt, kann das Etui 31 auch als tragbares Taschenterminal ausgebildet sein mit einem Sichtfenster 33 für optische Identitätsinformationen beim nichtautomatischen Gebrauch z. B. am Bankschalter, mit einer Tastatur 34 und einem Display 35, was dem Kunden den Abruf seines aktuellen Kontostandes oder anderer gespeicherten Informationen ermöglicht. Zusätzlich kann auch ein kleiner Rechner vorgesehen werden, der mit einem Speicher versehen auch externe Finanzkalkulationen gestattet, ohne den Speicherinhalt des IC-Bausteins in der Ausweiskarte zu beeinflußen. Weiter kann das Etui mit einem Reinigungsmechanismus versehen sein, der die Verschmutzung der Ausweiskarte und eventuell an der Oberfläche liegender Kontakte beseitigt. Dies ist insbesondere dann von nteresse, wenn die Ausweiskarte vom Karteninhaber auch aus dem Etui entnehmbar ist. In einer einfachen Ausführungsform kann auch auf Rechner, Display und Tastatur verzichtet werden, so daß das Etui nur als Schutzhülle vor äußeren mechanischen und elektrischen Einflüßen fungiert. Die Ausweiskarte mit dem IC-Baustein befindet sich also während des normalen Gebrauchs ständig in einem Faraday' schen Käfig und ist somit vor der Wirkung statischer Aufladungen oder elektrischer Felder geschützt. Vorteilhaft bei diesen Ausführungsformen ist, daß sie keine besonderen Materialien oder spezielle Verfahren bei der Herstellung der Karte und des Trägerelements erforderlich machen, sondern praktisch für jede beliebige Karte mit IC-Baustein verwendet werden können. Diese Ausführungsform kann demnach auch als nachträgliche Schutzmaßnahme für bereits hergestellte Ausweiskarten ohne integrierten Faradaykäfig verwendet werden.

**Patentansprüche**

1. Ausweiskarte mit in einem Trägerelement eingelagertem IC-Baustein zur Verarbeitung elektrischer Signale, mit einem den IC-Baustein einschließlich der zu seinem Betrieb notwendigen Kopplungsmittel vollständig umgebenden isolierenden Material und einer zumindest den Bereich des IC-Bausteins überdeckenden, als Faradaykäfig dienenden elektrisch leitfähigen Schichtanordnung, dadurch gekennzeichnet, daß die elektrisch leitfähige Schichtanordnung auf dem isolierenden Material zumindest auch den Bereich der Kopplungselemente überdeckt.

2. Ausweiskarte nach Anspruch 1, dadurch gekennzeichnet, daß die elektrisch leitfähige Schichtanordnung als Gitter oder Netz ausgebildet ist.

3. Ausweiskarte nach Anspruch 1 oder 2, dadurch gekennzeichnet, daß die elektrisch leitfähige Schichtanordnung als dünne, z. B. aufgedampfte, Schicht, in Form einer Umhüllung ausgebildet ist.

4. Ausweiskarte nach Anspruch 1 oder 2, dadurch gekennzeichnet, daß die elektrisch leitfähige Schichtanordnung elastiche Eigenschaften hat.

5. Ausweiskarte nach einem oder mehreren der vorhergehenden Ansprüche, dadurch gekennzeichnet, daß die elektrisch leitfähige Schichtanordnung bei optoelektronischer Kopplung in dem verwendeten Spektralbereich transparent ist.

6. Ausweiskarte nach einem oder mehreren der vorhergehenden Ansprüche, dadurch gekennzeichnet, daß die elektrisch leitfähige Schichtanordnung im Kartenaufbau vorgesehen ist.

7. Ausweiskarte nach einem oder mehreren der vorhergehenden Ansprüche, dadurch gekennzeichnet, daß die elektrisch leitfähige Schichtanordnung am Trägerelement selbst vorgesehen ist.

8. Ausweiskarte nach einem oder mehreren der vorhergehenden Ansprüche, dadurch gekennzeichnet, daß die elektrisch leitfähige Schichtanordnung aus Deckfolien gebildet ist.

9. Ausweiskarte nach Anspruch 8, dadurch gekennzeichnet, daß die elektrisch leitfähigen Deckfolien eine elektrisch leitfähige Randverschweißung aufweisen.

10. Ausweiskarte nach einem oder mehreren der vorhergehenden Ansprüche, dadurch gekennzeichnet, daß die elektrisch leitfähige Schichtanordnung partiell im Bereich des IC-Bausteins im Kartenaufbau oder auf den Deckfolien vorgesehen sind.

11. Ausweiskarte nach Anspruch 10, dadurch gekennzeichnet, daß die elektrisch leitfähige Schichtanordnung durch eine Art Durchkontaktierung miteinander leitend verbunden sind.

12. Ausweiskarte nach Anspruch 10 oder 11, dadurch gekennzeichnet, daß die elektrisch leitfähige Schichtanordnung partiell aufgedruckt bzw. aufgeklebt und dann leitend verbunden werden.

13. Ausweiskarte nach Anspruch 10 und 11, dadurch gekennzeichnet, daß die elektrisch leitfähige Schichtanordnung als Gitter oder Netz ausgebildet sind.

14. Ausweiskarte nach Anspruch 1, dadurch gekennzeichnet, daß die elektrisch leitfähige Schichtanordnung von der Karte entfernbar ist.

15. Ausweiskarte nach Anspruch 1 und 14, dadurch gekennzeichnet, daß die elektrisch leitfähige Schichtanordnung als Schutzetui ausgebildet ist.

16. Ausweiskarte nach Anspruch 14 und 15, dadurch gekennzeichnet, daß die elektrisch leitfähige Schichtanordnung ein ebenfalls leitfähiges Sichtfenster zur Sichtbarmachung wichtiger Daten aufweist.

17. Ausweiskarte nach den Ansprüchen 15, 16, dadurch gekennzeichnet, daß das Schutzetui mit einer Kontaktiereinheit und einer Kommunikationseinrichtung versehen ist.

18. Ausweiskarte nach einem oder mehreren der Ansprüche 15 bis 17, dadurch gekennzeichnet, daß das Schutzetui mit einer Reinigungsvorrichtung für die Kontakte und die Karte versehen ist.

19. Vorrichtung zum Betrieb der Ausweiskarte nach Anspruch 1, deren Kontaktnadeln bei galvanischer Kontaktabnahme die isolierende Umhüllung und die leitfähige Schichtanordnung durchstechen, dadurch gekennzeichnet, daß die Kontaktnadeln (18) abgesehen von der Spitze (20) mit einer isolierenden Umhüllung (19) versehen sind.

**Claims**

1. An identification card having an IC module embedded in a carrier element for processing electrical signals, an insulating material completely surrounding the IC module including the coupling means necessary for its operation, and an electrically conductive layer assembly covering at least the area of the IC module and serving as a Faraday cage, characterized in that the electrically conductive layer assembly on the insulating material covers as well at least the area of the coupling elements.

2. The identification card as in claim 1, characterized in that the electrically conductive layer assembly is designed as a lattice or net.

3. The identification card as in claim 1 or 2, characterized in that the electrically conductive layer assembly is designed as a thin, e. g. vapordeposited, layer in the form of a sheath.

4. The identification card as in claim 1 or 2, characterized in that the electrically conductive layer assembly has elastic properties.

5. The identification card as in one or more of the above claims, characterized in that the electrically conductive layer assembly, in the case of optoelectronic coupling, is transparent in the spectral range used.

6. The identification card as in one or more of the above claims, characterized in that the electrically conductive layer assembly is provided in the card construction.

7. The identification card as in one or more of the above claims, characterized in that the electrically conductive layer assembly is provided on the carrier element itself.

8. The identification card as in one or more of the above claims, characterized in that the electrically conductive layer assembly is formed of cover films.

9. The identification card as in claim 8, characterized in that the electrically conductive cover films exhibit an electrically conductive welded border.

10. The identification card as in one or more of the above claims, characterized in that the electrically conductive layer assembly is provided partly in the area of the IC module in the card construction or on the cover films.

11. The identification card as in claim 10, characterized in that the electrically conductive layer assembly is joined together conductively by a kind of throughplating.

12. The identification card as in claim 10 or 11, characterized in that the electrically conductive layer assembly is partly printed or glued on and then conductively joined.

13. The identification card as in claims 10 and 11, characterized in that the electrically conductive layer assembly is designed as a lattice or net.

14. The identification card as in claim 1, characterized in that the electrically conductive layer assembly is capable of being removed from the card.

15. The identification card as in claims 1 and 14, characterized in that the electrically conductive layer assembly is designed as a protective case.

16. The identification card as in claims 14 and 15, characterized in that the electrically conductive layer assembly exhibits a display window, which is also conductive, for displaying important data.

17. The identification card as in claims 15, 16, characterized in that the protective case is provided with a contacting unit and a communication device.

18. The identification card as in one or more of claims 15 to 17, characterized in that the protective case is provided with an apparatus for cleaning the contacts and the card.

19. An apparatus for operating the identification card as in claim 1, whose contact needles penetrate the insulating sheath and the conductive layer assembly in the case of galvanic contacting, characterized in that the contact needles (18) are provided with an insulating sheath (19) except for their tips (20).

## Revendications

1. Carte d'identification comportant un composant à circuit intégré pour le traitement de signaux électriques qui est inséré dans un élément porteur, une matière isolante entourant complètement le composant à circuit intégré y compris les moyens de couplage nécessaire à son fonctionnement et une structure de couches électriquement conductrices recouvrant la zone du composant à circuit intégré et servant de cage de Faraday, caractérisée en ce que la structure de couches électriquement conductrices formée de la matière isolante recouvre également au moins la zone des éléments de couplage.

2. Carte d'identification selon la revendication 1, caractérisée en ce que la structure de couches électriquement conductrices est agencée comme une grille ou un réseau.

3. Carte d'identification selon la revendication 1 ou 2, caractérisée en ce que la structure de couches électriquement conductrices est agencée comme une couche mince, par exemple formée par vaporisation sous la forme d'une enveloppe.

4. Carte d'identification selon la revendication 1 ou 2, caractérisée en ce que la structure de couches électriquement conductrices possède des propriétés élastiques.

5. Carte d'identification selon une ou plusieurs des revendications précédentes, caractérisée en ce que la structure de couches électriquement conductrices est transparente dans le domaine spectral utilisé, dans le cas d'un couplage optoélectronique.

6. Carte d'identification selon une ou plusieurs des revendications précédentes, caractérisée en ce que la structure de couches électriquement conductrices est prévue dans le corps de carte.

7. Carte d'identification selon une ou plusieurs des revendications précédentes, caractérisée en ce que la structure de couches électriquement conductrices est prévue sur l'élément porteur proprement dit.

8. Carte d'identification selon une ou plusieurs des revendications précédentes, caractérisée en ce que la structure de couches électriquement conductrices est formée de feuilles de recouvrement.

9. Carte d'identification selon la revendication 8, caractérisée en ce que les feuilles de recouvrement électriquement conductrices comportent une soudure périphérique électriquement conductrice.

10. Carte d'identification selon une ou plusieurs des revendications précédentes, caractérisée en ce que la structure de couches électriquement conductrices est disposée en partie dans la zone du composant à circuit intégré dans le corps de la carte ou bien sur les feuilles de recouvrement.

11. Carte d'identification selon la revendication 10, caractérisée en ce que, dans la structure de couches électriquement conductrices, les couches conductrices sont liées de façon conductrice entre elles par un genre de système à contact traversant.

12. Carte d'identification selon la revendication 10 ou 11, caractérisée en ce que, dans la structure de couches électriquement conductrices, les couches sont imprimées ou bien collées partiellement et sont ensuite reliées de façon conductrice.

13. Carte d'identification selon les revendications 10 et 11, caractérisée en ce que la structure de couches électriquement conductrices est agencée comme une grille ou un réseau.

14. Carte d'identification selon la revendication 1, caractérisée en ce que la structure de couches électriquement conductrices peut être enlevée de la carte.

15. Carte d'identification selon les revendications 1 et 14, caractérisée en ce que la structure de couches électriquement conductrices est agencée par un étui protecteur.

16. Carte d'identification selon les revendications 14 et 15, caractérisée en ce que la structure de couches électriquement conductrices comporte une fenêtre, également conductrice, pour visualiser des données importantes.

17. Carte d'identification selon les revendications 15, 16, caractérisée en ce que l'étui protecteur est pourvu d'une unité d'établissement de contacts et d'un dispositif de communication.

18. Carte d'identification selon une ou plusieurs des revendications 15 à 17, caractérisée en ce que l'étui protecteur est pourvu d'un dispositif de nettoyage des contacts et de la carte.

19. Dispositif d'utilisation de la carte d'identification selon la revendication 1, dont des broches de contact perforent, lors de l'établissement galvanique de contact, l'enveloppe isolante et la structure de couches conductrices, caractérisé en ce que les aiguilles de contact (18) sont pourvues, à l'exception de la pointe (20), d'une enveloppe isolante (19).

*Fig.1*

*Fig.2*

*Fig.3*

*Fig.4*

*Fig.5*

29  28                                                                    27

29

30

*Fig.6*

                                                                18

                                                                19

24   16   17                                                    20

23                                                              24

                                                               17a

22                                                21

*Fig.7*

                        24

25

                        26

*Fig. 8*